# EUROPEAN PATENT SPECIFICATION

(11) **EP 2 237 316 B1**
(45) Date of publication and mention of the grant of the patent: **09.10.2019**
(21) Application number: 09706254.1
(22) Date of filing: 30.01.2009
(51) Int. Cl.: H01L 23/498, H01L 23/04, H01L 23/02, H01L 23/12

(54) **CONNECTION TERMINAL, PACKAGE USING THE SAME AND ELECTRONIC DEVICE**
VERBINDUNGSANSCHLUSS, DIESEN VERWENDENDE KAPSELUNG UND ELEKTRONISCHE ANORDNUNG
BORNE DE CONNEXION, BOITIER UTILISANT LADITE BORNE ET DISPOSITIF ELECTRONIQUE

(30) Priority: 30.01.2008 JP 2008019795; 30.01.2008 JP 2008019796
(43) Date of publication of application: 06.10.2010
(73) Proprietor: Kyocera Corporation, Kyoto-shi Kyoto 612-8501 (JP)
(72) Inventor: TSUJINO, Mahiro, Higashiomi-shi Shiga 529-1595 (JP)
(74) Representative: Viering, Jentschura & Partner mbB Patent- und Rechtsanwälte
(86) International application number: PCT/JP2009/051618
(87) International publication number: WO 2009/096542

(56) References cited:
- EP-A2- 0 275 973
- JP-A- H01 214 051
- JP-A- 2001 144 509
- JP-A- 2002 043 460
- JP-A- 2004 356 391
- JP-A- 2005 108 891
- JP-A- 2006 210 672
- JP-U- 63 115 227

## Description

### Technical Field

The present invention relates to a connector (or a connecting terminal), a package using the same and an electronic device.

### Background Art

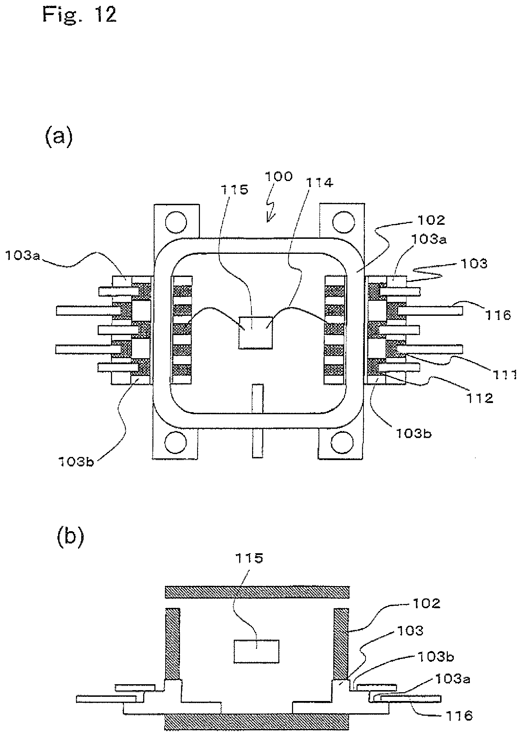

Fig. 12(a) is a plan view showing a conventional electronic device 100 having a connector 103, and Fig. 12(b) is a sectional view of the electronic device 100.

The electronic device 100 comprises a package having a frame 102 and the connector 103, and an electronic component 115 such as semiconductor element housed in the package.

The connector (input/output terminal) 103 is disposed below the frame 102 of the container of the package. One end of the connector 103 located outside of the frame 102 is connected via a lead 116 to an external circuit, while the other end located inside of the frame 102 is connected via a bonding wire 114 to the electronic component (internal circuit) 115. Thus the external circuit and the electronic component 115 are electrically connected with each other.

The connector 103 has two kinds of conductor; first conductor 111 and second conductor 112.

The first conductor 111 is disposed on a first flat portion (top surface of a first dielectric layer) 103a formed from ceramics extending from the outside of the frame 102 toward the inside, and extends from the outside of the frame 102 toward the inside similarly to the first dielectric layer.

The first conductor 111 has a first external connecting terminal connected to the lead 116 outside of the frame 102, and has a first internal connecting terminal connected to the bonding wire 114 in the frame 102.

The second conductor 112 extends on a second flat portion (top surface of a second dielectric layer) 103b formed from ceramics on the outside of the frame 102. Within the frame 102, the second conductor 112 extends on the first flat portion 103a similarly to the first conductor 111.

The second conductor 112 has a second external connecting terminal connected to the lead 116 outside of the frame 102, and has a second internal connecting terminal connected to the bonding wire 114 in the frame 102.

The second flat portion 103b is disposed above the first flat portion 103a, with a step existing between the second flat portion 103b and the first flat portion 103a.

As described above, since the first and second external connecting terminals are disposed on the top surface of the first flat portion 103a and the top surface of the second flat portion 103b which are separate planes, the connector tends to protrude to the outside.

The first and second internal connecting terminals, on the other hand, are arranged along the frame 102 on the same plane, and the length of the arrangement tends to be longer.

As a result, the connector described above is likely to become large, and may cause the package using the connector and the electronic device 100 using the package to become large.

Another conventional connector is described in Patent Document 2.
Patent Document 1: JP2004-356391A
Patent Document 2: JP H01 214051

### Summary of Invention

### Technical Problem

The present invention has been made to solve the problem described above and an object thereof is to provide a connector that can be reduced in size. Another object of the present invention is to provide a package and an electronic device that can be reduced in size.

### Solution to Problem

The problem is solved by the connector according to claim 1. Advantageous additional aspects follow from the dependent claims.

### Advantage

Use of the connector described above enables it to make the connector smaller. Use of the connector described above also enables it to make the package and the electronic device smaller.

### Brief Description of Drawings

Fig. 1 shows a connector 6 according to the first embodiment of the present invention, Fig. 1(a) is a sectional view of the connector 6 taken along lines X-X' in Fig. 1(b), and Fig. 1(b) is a plan view of the connector 6.
Fig. 2 is a sectional view showing a connector 6a according to the first embodiment of the present invention.
Fig. 3 shows a connector 6a, Fig. 3(a) is a perspective view thereof, and Fig. 3(b) is an exploded perspective view thereof.
Fig. 4 is a plan view showing a connector 6b according to the first embodiment of the present invention.
Fig. 5 shows a connector 6c according to the first embodiment of the present invention, Fig. 5(a) is a perspective view thereof, and Fig. 5(b) is an exploded perspective view thereof.
Fig. 6 show a connector 6d according to the second embodiment of the present invention, Fig. 6(a) is a sectional view of the connector 6d taken along lines X-X' in Fig. 6(b), and Fig. 6(b) is a plan view of the connector 6d.
Fig. 7 shows a connector 6d, Fig. 7(a) is a perspective view thereof, and Fig. 7(b) is an exploded perspective view thereof.
Fig. 8 shows a connector 6e according to the second embodiment of the present invention, Fig. 8(a) is a sectional view of the connector 6e taken along line Y-Y' of Fig. 8(b), and Fig. 8(b) is a perspective view showing the connector 6e.
Fig. 9 shows a connector 6e, Fig. 9(a) is a perspective view thereof, and Fig. 9(b) is an exploded perspective view thereof.
Fig. 10 shows a connector 6f according to the second embodiment of the present invention, Fig. 10(a) is a perspective view of thereof, and Fig. 10(b) is an exploded perspective view thereof.
Fig. 11 shows a package 30 and an electronic device 50 according to the third embodiment of the present invention, Fig. 11(a) is a schematic plan view thereof, and Fig. 11(b) is a schematic sectional view thereof.
Fig. 12 shows a conventional package and a conventional electronic device 100, Fig. 12(a) is a plan view thereof, and Fig. 12(b) is a sectional view thereof.

### Reference Signs List

1: Dielectric substrate layer
1a: First dielectric layer
1b: Second dielectric layer
1c: Third dielectric layer
1d: Fourth dielectric layer
1e: Fifth dielectric layer
1f: Sixth dielectric layer
2a: First conductor
2a-1: First external connecting terminal
2a-2: First internal connecting terminal
2b, 2b₁, 2b₂: Second conductor
2b-1: Second external connecting terminal
2b-2: Second internal connecting terminal
2b-3: Internally extended portion of the second conductor
2c: Third conductor
2c-1: Third external connecting terminal
2c-2: Third internal connecting terminal
2c-3: Internally extended portion of the third conductor
3: Grounding conductor
4: Metal layer
5: Via hole conductor
6, 6a, 6b, 6c, 6d, 6e, 6f: connector
7a: Flat part
7b: Step portion
8: Notch
9a: First end of the connector
9b: Second end of the connector
10: Container
11: Cavity
12: Frame
13: Aperture
14: Bonding wire
15: electronic component
20: Lid
30: Package
50: Electronic device

### Description of Embodiments

Embodiments of the present invention will be described in detail below with reference to the accompanying drawings. While terms indicating particular directions or positions (such as top, bottom, right, left and other phrases including these) are used in the following description, these terms are used for making it easier to understand the present invention with reference to the accompanying drawings. It should be noted that meanings of these terms do not limit the technical scope of the present invention. Identical reference numerals used in plural drawings denote the identical portions or members.

The connector of the present invention, and the package and the electronic device using the same will be described in detail below.

### 1. First embodiment

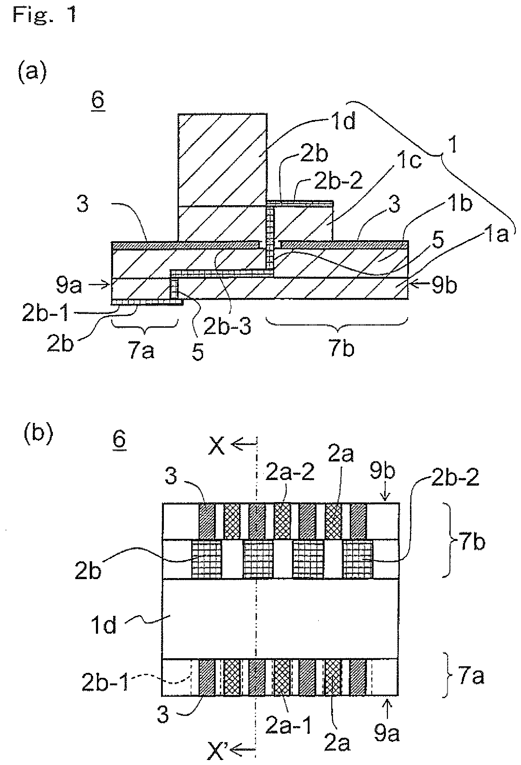

Fig. 1 is a view showing the connector 6 according to the first embodiment of the present invention. Fig. 1(a) is a sectional view of the connector 6 taken along lines X-X' in Fig. 1(b), and Fig. 1(b) is a plan view of the connector 6.

As shown in Fig. 1, the connector 6 of the first embodiment comprises conductors comprising the first conductor 2a and the second conductor 2b provided on the surface and inside of a dielectric substrate 1.

Specifically, the dielectric substrate 1 has multilayer structure wherein three dielectric layers of first dielectric layer 1a, second dielectric layer 1b and third dielectric layer 1c are disposed in parallel in this order from the bottom as shown in Fig. 1(a). It is preferable that a fourth dielectric layer 1d is disposed on the third dielectric layer 1c as shown in Fig. 1(a), 1(b) in the present embodiment.

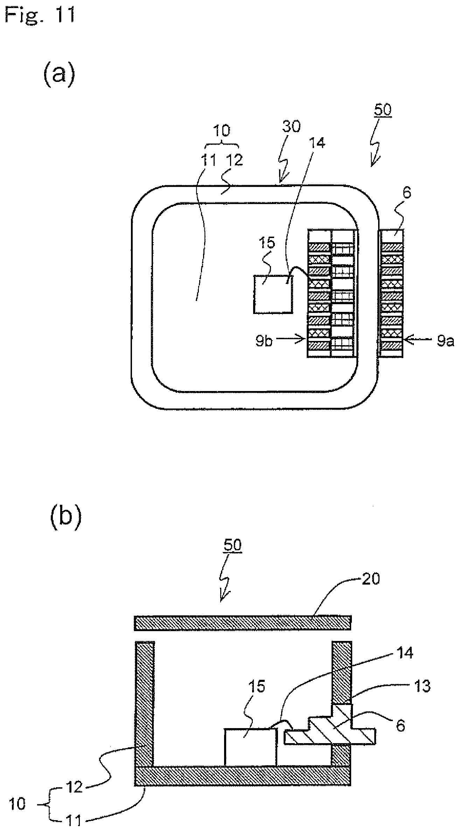

Providing the fourth dielectric layer 1d enables it to reinforce the connector 6. As a result, the connector 6 can be made less likely to be damaged even when the connector 6 is bonded onto the frame 12 as shown in Fig. 11(a) and 11(b) and is subjected to a stress caused by the difference in thermal expansion with the frame 12.

Disposed on the top surface of the second dielectric layer 1b is one or more, preferably a plurality of the first conductors 2a extending from a first end 9a to a second end 9b of the connector 6.

In the dielectric substrate 1, positions of both ends of the first dielectric layer 1a and the second dielectric layer 1b are aligned in the extending direction of the first conductor 2a. In contrast, both ends of the third dielectric layer 1c are positioned inward from both ends of the second dielectric layer 1b. As a result, a step portion 7b is formed on the side of the second end 9b.

Moreover, ends of the third and fourth dielectric layers 1c, 1d are aligned on the first end 9a side, and end of the fourth dielectric layer 1d is positioned inward from the end of the third dielectric layer 1c on the second end 9b side. The first conductor 2a has exposed portions not covered by the third dielectric layer 1c or the fourth dielectric layer 1d on the first end 9a side and on the second end 9b side.

The exposed portion of the first conductor 2a on the first end 9a side functions as a first external connecting terminal 2a-1 that connects to lead or the like connected to an external circuit. The exposed portion of the first conductor 2a on the second end 9b side, on the other hand, functions as a first internal connecting terminal 2a-2 that connects to a bonding wire connected to an internal circuit such as electronic component disposed in the package.

The connector 6 also has one or more, preferably a plurality of the second conductors 2b. The second conductor 2b comprises a second external connecting terminal 2b-1 formed on the bottom surface of the first dielectric layer 1a, a second internal connecting terminal 2b-2 disposed on the top surface of the third dielectric layer 1c, and an internal connection conductor connecting between the second external connecting terminal 2b-1 and the second internal connecting terminal 2b-2.

The internal connection conductor comprises a via hole conductor 5 connected to the second external connecting terminal 2b-1 and penetrating through the first dielectric layer 1a, an extension 2b-3 connected to the via hole conductor 5 and formed on the top surface of the first dielectric layer 1a, and via hole conductor 5 connected to the extension 2b-3 and penetrating through the second dielectric layer 1b and the third dielectric layer 1c, as shown in Fig. 1(a).

While the via hole conductor 5 penetrating through the first dielectric layer 1a and the via hole conductor 5 penetrating through the third dielectric layer are shown in the drawing as each being constituted from one conductor, such a constitution may also be employed that each comprises a plurality of via hole conductors 5 depending on the current capacity of the second conductor 2b.

The extension 2b-3 is formed on the top surface of the first dielectric layer 1a, for the consideration of a case where the frame 12 of the package 30 shown in Fig. 11 to be described later is formed from a metal. That is, the first dielectric layer 1a is provided for the purpose of insulating between the extension 2b-3 and the metallic frame 12 by means of the first dielectric layer 1a. Therefore, when the frame 12 is an insulating material, the extension 2b-3 may also be disposed on the bottom surface of the first dielectric layer 1a similarly to the second external connecting terminal 2b-1, or the second external connecting terminal 2b-1 and the extension 2b-3 may be disposed on the bottom surface of the second dielectric layer 1b while omitting the first dielectric layer 1a.

As described above, the second conductor 2b is formed on a plane different from that of the first conductor 2a. Also because the extending direction of the first conductor 2a and the extending direction of the second conductor 2b do not become parallel to each other on the same plane, it is easier to decrease the width of the connector 6 in a direction perpendicular to the line X-X' of Fig. 1(b). This contributes to the size reduction of the connector.

The second external connecting terminal 2b-1 is disposed on the bottom surface of the first dielectric layer 1a, and is in a plane different from that of the first external connecting terminal 2a-1. Also as shown in Fig. 1(b), the first and second external connecting terminals 2a-1, 2b-1 are arranged in a direction perpendicular to the line X-X' of Fig. 1(b) along the first end 9a, so that positions thereof overlap with each other in the direction parallel to the line X-X'. This configuration enables it to decrease the space for disposing the first external connecting terminal and the second external connecting terminal in the direction parallel to the line X-X'.

The lead can be easily connected regardless of whether the external connecting terminal is connected to the top surface or the bottom surface of the dielectric layer in the same manner. Therefore, there occurs no problem for the operation of connecting the lead if the first external connecting terminal 2a-1 and the second external connecting terminal 2b-1 are disposed on the top surface and the bottom surface, respectively, as described above.

Moreover, the second internal connecting terminal 2b-2 of the second conductor 2b is disposed on the top surface of the third dielectric layer 1c at a position higher than and inside (nearer to the fourth dielectric layer 1d) the first internal connecting terminal 2a-2. This configuration enables it to easily connect bonding wires to both the first internal connecting terminal 2a-2 and the second internal connecting terminal 2b-2.

For the bonding wire, unlike the lead, it is very difficult to carry out wire bonding operation with the ordinary wire bonding apparatus if the internal connecting terminal is formed on the bottom surface of the dielectric layer. In contrast, when the first internal connecting terminal 2a-2 and the second internal connecting terminal 2b-2 are formed on the top surface of the dielectric layer as described above, there is no inconvenience in wire bonding operation despite the presence of the step portion 7b.

Also because the bonding wire is far smaller in diameter than the lead, length of the internal connecting terminal required for connecting the bonding wire is less than that of the external connecting terminal required for connecting the lead. Thus by disposing the first internal connecting terminal 2a-2 and the second internal connecting terminal 2b-2 stepwise in the connector 6, it is made easier to make the portion of the first internal connecting terminal 2a-2 protruding toward the inside of the package (toward the second end 9b side) shorter than the portion of the external connecting terminal protruding toward the outside of the package.

The connector 6 is suitable for use as a connector for transmitting high-frequency signals (for example, 10 GHz or more). High-frequency signals are more likely to experience transmission loss as the bonding wire becomes longer. The first conductor 2a is formed on the lower surface of the step portion 7b, and therefore can reach a position nearer to the electronic component within the package, so that the length of the bonding wire can be made shorter. Therefore, high-frequency signals are transmitted through the first conductor 2a. In this case, the second conductor 2b is used transmit DC signals or low-frequency signals having lower frequencies than those of the high-frequency signals (for example, 1 MHz or less), which are less affected by the length of the bonding wire, rather than high-frequency signals.

It is preferable to form the first conductor 2a to run straight from the first end 9a side to the second end 9b side in a same plane (top surface of the second dielectric layer 1b) in the connector 6 as shown in Fig. 1. With this configuration, signals transmitted by the first conductor 2a propagate without changing the direction of propagation in the same plane, and therefore transmission loss can be suppressed from increasing. This is particularly advantageous in case frequency of the signals transmitted by the first conductor 2a is higher than that of the signals transmitted by the second conductor 2b. Also because the first conductor 2a having straight line configuration can be formed altogether on the top surface of the second dielectric layer 1b by a printing method such as screen printing, excellent workability can be achieved during manufacturing.

For high-frequency signals transmitted by the first conductor 2a, the connector according to the invention provides a grounding conductor (conductor for earth) 3, to be electrically connected to an external grounding circuit, on the top surface of the second dielectric layer 1b to adjoin the first conductor 2a, as shown in Fig. 1(b). Alternatively, a coplanar transmission line of G (ground)-S (signal)-G (ground) structure can be formed by the first conductor 2a and the grounding conductor 3.

Forming the coplanar transmission line of G-S-G structure enables it to stabilize the impedance of the first conductor 2a at a predetermined value. In this constitution, the first conductor 2a can transmit high-frequency signals with higher efficiency.

Fig. 1(b) shows the first conductor 2a and the conductor for earth 3 arranged in the order of G-S-G, although the first conductor 2a and the conductor for earth 3 may also be arranged in the order of G-S-S-G.

In this case, the two first conductors 2a interposed between the conductors for earth 3 can be functioned as a differential-mode transmission line constituted by a pair of the first conductors 2a. This constitution enables coupled transmission of the electric signals transmitted by the two first conductors 2a, so that transmission loss of the electric signals transmitted by the two first conductors 2a can be decreased. As a result, electric signals can be transmitted over the two first conductors 2a with less attenuation.

Dielectric layers adjoining one over another, such as the first dielectric layer 1a and the second dielectric layer 1b, or the second dielectric layer 1b and the third dielectric layer 1c, may be integrated by firing. In this case, some of the conductors (for example, the first conductor 2a, the second conductor 2b, the grounding conductor 3) that is disposed between the dielectric layers has the form of internal wiring.

### First variation of first embodiment

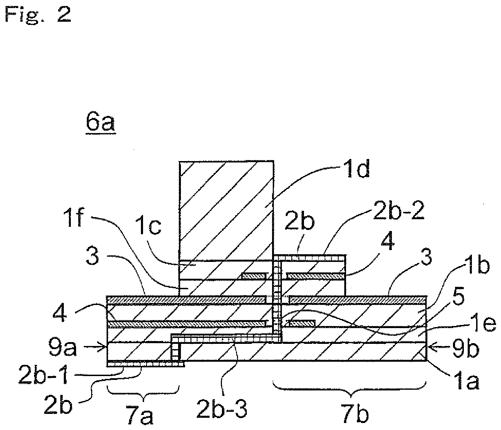

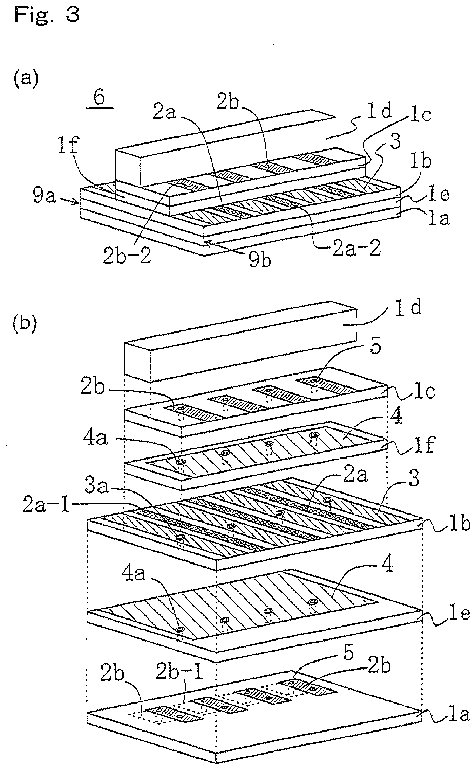

Fig. 2 is a sectional view showing a connector 6a according to a variation of the first embodiment. Fig. 3(a) is a perspective view of the connector 6a, and Fig. 3(b) is an exploded perspective view of the connector 6a.

The connector 6a has such a constitution as, in addition to the same constitution of the connector 6 shown in Fig. 1(a), a fifth dielectric layer 1e having a metal layer 4 formed on the top surface thereof is disposed between the second dielectric layer 1b and the third dielectric layer 1a, and a sixth dielectric layer 1f having the metal layer 4 formed on the top surface thereof is disposed between the second dielectric layer 1b and the third dielectric layer 1c.

In this constitution, the metal layers 4 are provided on the upper and lower sides of the first conductor 2a, so that the metal layers 4 having shielding effect can be interposed between the first conductor 2a and the second conductor 2b.

As a result, the metal layers 4 held at a predetermined potential are disposed around the first conductor 2a, so that noise can be suppressed from entering the first conductor 2a. Even when conductors such as the second conductor 2b are disposed nearby, interference with such conductors can be avoided. Thus impedance of the first conductor 2a can be made less susceptible to disturbance, thereby making it easier to design the first conductor 2a. Therefore the connector 6a capable of transmitting high-frequency electrical signals through the first conductor 2a having high reliability and less affected by electromagnetic interference is provided.

### Second variation of first embodiment

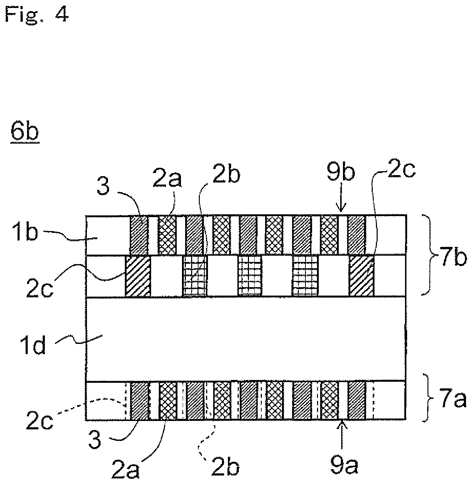

Fig. 4 is a plan view showing a connector 6b according to another variation of the first embodiment.

In the connector 6b, it is preferable to dispose the first conductor 2a and the second conductor 2b at positions offset in the direction perpendicular to the longitudinal direction of the first conductor 2a, so that the first conductor 2a and the second conductor 2b do not oppose each other.

In the aspect of variation shown in Fig. 4, the first conductor 2a is disposed to run between adjoining second conductors 2b in plan view. The conductor for earth 3 is provided right below or right above the second conductor 2b.

With this arrangement, the via hole conductor 5 forming a part of the second conductor 2b can be disposed between the first conductors 2a.

Also because the first conductor 2a is disposed in a staggered arrangement in a plane with respect to the second conductor 2b, distance between the first conductor 2a and the second conductor 2b can be made larger than in the case of disposing these members to overlap each other.

As a result, troubles can be suppressed from being caused by electromagnetic coupling between the first conductor 2a and the second conductor 2b. In other words, it is made possible to suppress electric field from being generated from the first conductor 2a to the second conductor 2b, and suppress the impedance of the first conductor 2a to the electrical signals transmitted thereby from deviating from the predetermined value.

For a reason similar to the first embodiment, high-frequency signals are transmitted through the first conductor 2a and DC signals or low-frequency signals through the second conductor 2b.

The second conductor 2b has a second conductor 2b₁ having high current capacity and a second conductor 2b₂ having current capacity lower than that of the second conductor 2b₁.

As the second conductor 2b₁ is disposed on the outside to interpose the second conductor 2b₂, the second conductor 2b₁ generating greater amount of heat than the second conductor 2b₂ does is disposed at a position near the ends of the first dielectric layer 1a and the third dielectric layer 1c. This is not only advantageous for dissipating heat from the second conductor 2b₁, but also enables it to suppress the permittivity of the dielectric layer from changing due to heat, thereby achieving stable transmission of electrical signals.

### Third variation of first embodiment

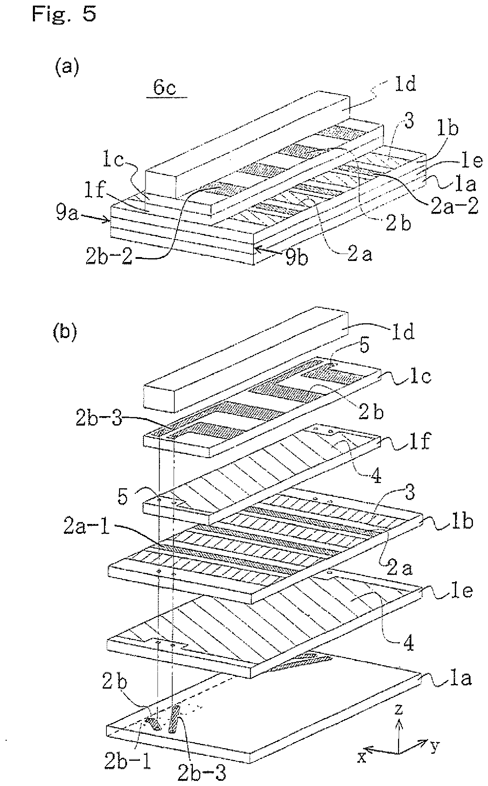

Fig. 5(a) is a perspective view showing a connector 6c according to further another variation of the first embodiment. Fig. 5(b) is an exploded perspective view showing the connector 6c.

The via hole conductor 5 of the connector 6c penetrates through vicinities of both ends of the dielectric layers 1b, 1c, 1e, 1f (both ends in y-axis direction in Fig. 5(b)), so as not to penetrate through the first conductor 2a, the grounding conductor 3 and the metal layer 4.

Therefore, this configuration makes it easier to insulate the via hole conductor 5 from the first conductor 2a, the grounding conductor 3 and the metal layer 4, than in the case of the connector 6 shown in Fig. 3, thus providing the advantage of excellent workability during manufacturing. Also because the via hole conductor 5 can be formed at a distance from the first conductor 2a, this configuration is advantageous also for achieving more stable impedance of the first conductor 2a. Moreover, the degree of freedom in design can be increased with regard to the interval of disposing the first conductor 2a, than in the case of disposing the via hole conductor 5 between a plurality of first conductors 2a.

In the connector 6c, the via hole conductors 5 are positioned near both ends of the dielectric layers 1a, 1b, 1c, 1e, 1f as described above. As a result, the extension 2b-3 of the second conductor 2b extends in an oblique direction (at an angle from x-axis direction in Fig. 5(b)) on the first end 9a side on the top surface of the first dielectric layer 1a, while it extends in a direction perpendicular to line connecting the first end 9a and the second end 9b (y-axis direction in Fig. 5(b)) on the top surface of the second dielectric layer 1b, and changes the direction to extend in the direction from the first end 9a to the second end 9b (x-axis direction in Fig. 5(b)). Since the second conductor 2b is longer than the first conductor 2a, it is used to transmit DC signals or low-frequency signals through the second conductor 2b.

### Respective elements of first embodiment and first to third variations of first embodiment

Elements that constitute connectors 6, 6a, 6b, 6c of the first embodiment and first to third variations thereof will be described in detail below.

It is possible to use, as the material of dielectric layers 1a, 1b, 1c, 1d, 1e, 1f, dielectrics such as ceramics, glass and resin. When the dielectric layers 1a, 1b are made of ceramics, a step portion 7b can be formed by a conventionally known ceramic green sheet stacking method with predetermined dimensional accuracy.

A first conductor 2a, a second conductor 2b, a grounding conductor for earth 3, and a third conductor 2c can be formed from a metallized layer of tungsten (W), molybdenum (Mo), manganese (Mn) or the like.

Furthermore, a via hole conductor 5 may be formed from a metallized layer of W, Mo, Mn or the like.

A metal layer 4 can be formed by applying a metal paste, that is prepared by adding an organic solvent, a solvent or the like to a powder of W, Mo, Mn or the like, followed by mixing, in a predetermined pattern by a screen printing method. It is also possible to form a first conductor 2a, a second conductor 2b,a grounding conductor for earth 3 and a third conductor 2c by this screen printing method.

### Method for manufacturing connector of first embodiment

The method for manufacturing connector 6 will be described in detail below.

Dielectric layers 1a, 1b, 1c, 1d are preferably formed from dielectrics such as alumina (Al₂O₃) ceramics, aluminum nitride (AlN) ceramics and mullite (3Al₂O₃ · 2SiO₂) ceramics and preferably obtained by a ceramic green sheet stacking method. It is possible to improve airtight reliability of the inside and outside of a connector 6 by using ceramics having higher airtight reliability than that of other dielectric materials such as resin and glass.

For example, when the dielectric layers 1a, 1b, 1c, 1d are Al₂O₃ sintered bodies, proper organic binders, solvents, plasticizers and dispersants are added to raw powders such as Al₂O₃, silicon oxide (SiO₂), magnesium oxide (MgO) and calcium oxide (CaO) powders, followed by mixing to obtain a paste, and then ceramic green sheets (ceramic unfired sheets) that are turned into the dielectric layers 1a, 1b, 1c, 1d is formed from the paste using a doctor blade method or a calendar roll method.

Next, an electrically conductive paste prepared by mixing a metal powder of W, Mo, Mn or the like with a proper binder and solvent is applied in a predetermined pattern by a screen printing method or the like at predetermined positions on the top surface of the ceramic green sheet used to form the second dielectric layer 1b thereby to form the electrically conductive paste layer that are turned into the first conductor 2a and the conductor 3.

Similarly, the electrically conductive paste described above is applied in a predetermined pattern by a screen printing method or the like at predetermined positions on the top surface and bottom surface of the ceramic green sheet that is turned into the first dielectric layer 1a and on the top surface of the ceramic green sheet used to form the third dielectric layer 1c, thereby to form the electrically conductive paste layer becoming a part of the second conductor 2b (a part excluding the via hole conductor 5).

Then the via hole conductors 5 are formed in the dielectric layers 1a, 1b and 1c. The via hole conductor 5 is formed by forming a through hole in the ceramic green sheet by using a die or the like, and filling the through hole with the electrically conductive paste described above.

After stacking the ceramic green sheets that are turned into the dielectric layers 1a, 1b, 1c, 1d, having been subjected to the process described above, in a predetermined order, the stack is fired at a temperature of about 1,600°C to obtain the connector 6.

The connector 6 can be formed easily by the method described above, thus making it possible to provide the connector 6 characterized by high manufacturing efficiency.

When manufacturing the connector 6a, the electrically conductive paste layer that is turned into the metal layer 4 can be formed by applying the electrically conductive paste described above in a predetermined pattern by screen printing or the like at predetermined positions on the top surfaces of the ceramic green sheets that are turned into the dielectric layers 1e, 1f obtained by the same method as that of the ceramic green sheets used to form the dielectric layers 1a, 1b, 1c, 1d described above.

Then the via hole conductors 5 are formed by the method described above in the ceramic green sheets that are turned into the dielectric layers 1e, 1f, and the ceramic green sheets that are turned into the dielectric layers 1a, 1b, 1c, 1d, 1e, 1f are stacked in the predetermined order and fired to obtain the connection terminal 6a.

### 2. Second embodiment (not part of the invention)

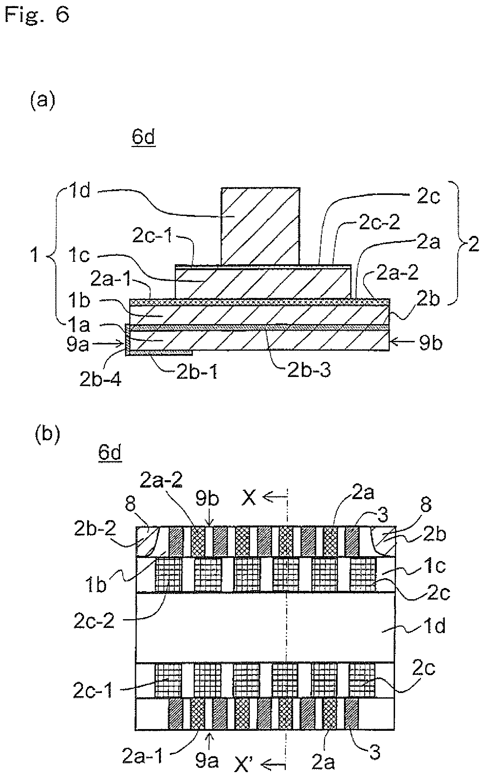

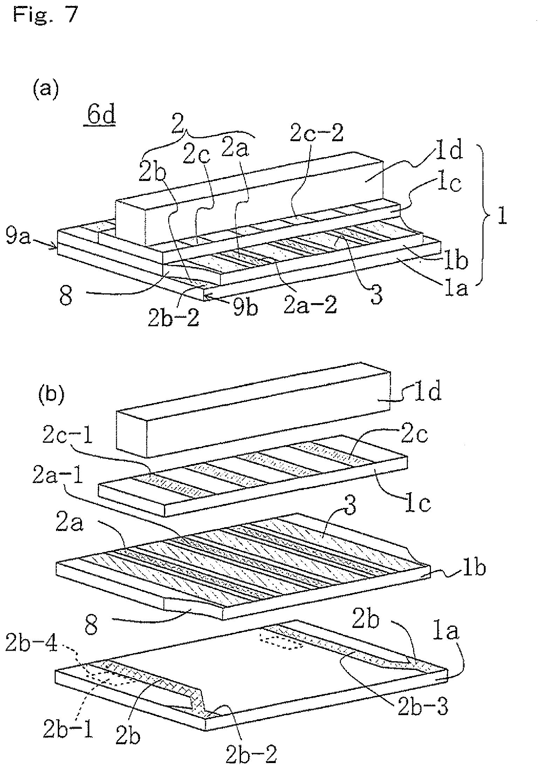

Fig. 6(a), 6(b) and Fig. 7(a), 7(b) show a connector 6d according to the second embodiment of the present invention. Fig. 6(b) is a plan view of the connector 6d, and Fig. 6(a) is a sectional view of the connector 6 taken along lines X-X' in Fig. 6(b). Fig. 7(a) is a perspective view of the connector 6d, and Fig. 7(b) is an exploded perspective view of the connector 6d.

Of the reference numerals (symbols) used in the drawings according to the second embodiment, those identical with the reference numerals (symbols) used in the drawings according to the first embodiment denote the same members as, or members corresponding to, the members described in the first embodiment, unless otherwise described.

The connector 6d has the first dielectric layer 1a and the second dielectric layer 1b disposed thereon. It is the same as the connector 6 of the first embodiment, that the first conductor 2a is formed on the top surface of the second dielectric layer 1b, and the first conductor 2a has the first external connecting terminal 2a-1 on the first end 9a side and the first internal connecting terminal 2a-2 on the second end 9b side.

In the connector 6d of the second embodiment, however, notches 8 are formed at corners on both ends of the second dielectric layer 1b, so that the second conductor 2b is exposed through the notches 8, thereby providing the second internal connecting terminal 2b-2. That is, in the connector 6d of the second embodiment, the second internal connecting terminal 2b-2 is formed on the top surface of the first dielectric layer 1a. Thus the second internal connecting terminal 2b-2 is formed in a plane different, hence at a different height, from the first internal connecting terminal 2a-2 formed on the top surface of the second dielectric layer 1b.

The second conductor 2b of the connector 6d extends through the end face of the first dielectric layer 1a on the first end 9a side to reach the bottom surface of the first dielectric layer 1a, and the second external connecting terminal 2b-1 is formed on the bottom surface of the first dielectric layer 1a similarly to the first embodiment.

Thus the entire path of the second conductor 2b of the connector 6d, from the second external connecting terminal 2b-1 to the second internal connecting terminal 2b-2, is disposed on the surface of the first dielectric layer 1a. That is, the second conductor 2b includes the second internal connecting terminal 2b-2, the top-surface extension 2b-3 connected to the second internal connecting terminal 2b-2 and extending from the second end 9b side to the first end 9a side on the top surface of the first dielectric layer 1a, the second external connecting terminal 2b-1 formed on the first end 9a side of the bottom surface of the first dielectric layer 1a, and the end-face extension 2b-4 positioned on the end face of the first dielectric layer 1a on the first end 9a side and connecting the top-surface extension 2b-3 and the second external connecting terminal 2b-1 together.

In the connector 6d of the second embodiment constituted as described above, it is not necessary to form a via hole conductor penetrating through the dielectric layers such as first dielectric layer 1a and the second dielectric layer 1b for providing the second external connecting terminal 2b-1, thus providing an advantage in terms of workability during manufacturing.

In the connector 6d of the second embodiment, the second conductor 2b does not run through the third dielectric layer 1c, unlike the connectors (the connectors 6, 6a, 6b, 6c) according to the first embodiment.

Further in the connector 6d of the second embodiment, as shown in Figs. 6(a) and 6(b), and Figs. 7(a) and 7(b), a third conductor 2c is provided on the third dielectric layer 1c, and the fourth dielectric layer 1d is provided on the third dielectric layer 1c so that both ends of the third conductor 2c are exposed.

Exposed portions of the third conductor 2c respectively function as the third external connecting terminal 2c-1 and as the third internal connecting terminal 2c-2. In this case, the third external connecting terminal 2c-1 is positioned between the first and second external connecting terminals 2a-1, 2b-1 and the fourth dielectric layer 1d, and therefore becomes larger in the direction parallel to line X-X' when compared with the first embodiment. In the second embodiment, however, despite the fact that three kinds of external connecting terminal exist, these external connecting terminals can be arranged in two rows, and therefore size in the direction of line X-X' can be decreased than that of the conventional art.

It goes without saying that the fourth dielectric layer 1d and the third conductor 2c may be omitted.

### First Variation of Second Embodiment

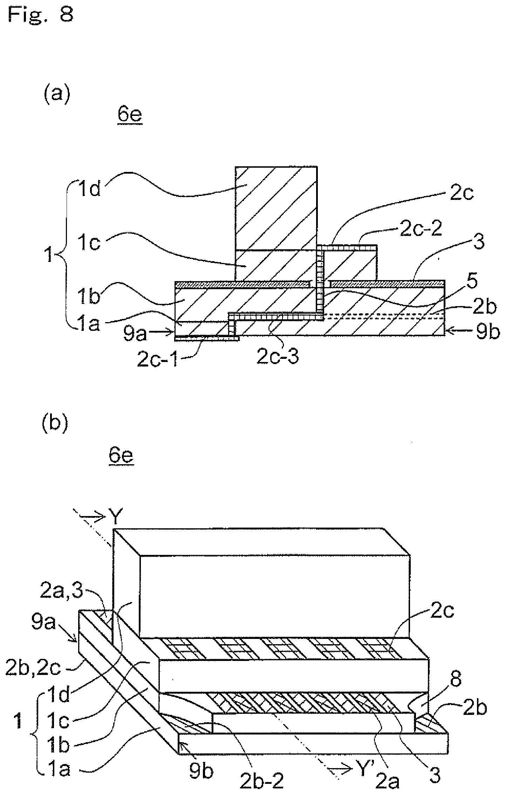

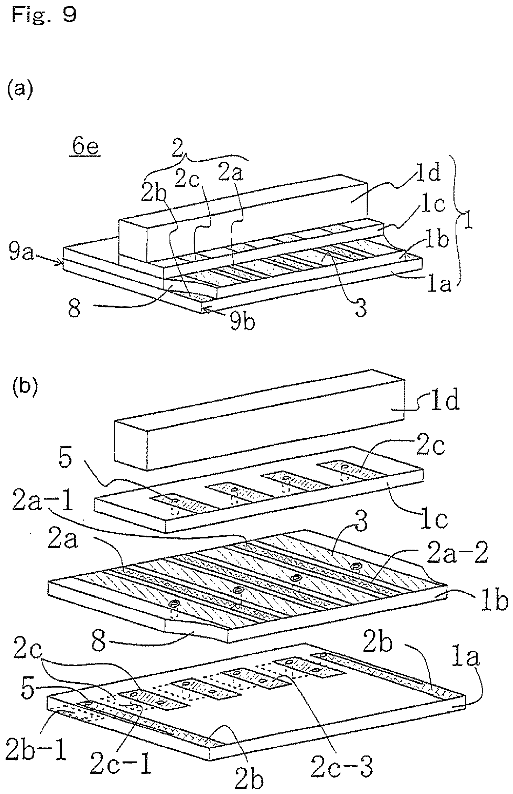

Figs. 8(a) and 8(b), and Figs. 9(a) and 9(b) show a connector 6e according to a variation of the connector 6d. Fig. 8(a) is a sectional view of the connector 6e, Fig. 8(b) and Fig. 9(a) are perspective views of the connector 6e, and Fig. 9(b) is an exploded perspective view of the connector 6e.

The connector 6e of the present variation has the same constitution as that of the second conductor 2b of the connector 6 according to the first embodiment. However, the present first variation has a constitution different from that of the connector 6 according to the first embodiment in that the connector 6e has the third conductor 2c, while the third conductor 2c extends from the top surface of the third dielectric layer 1c through the top surface of the second dielectric layer 1b to the bottom surface of the first dielectric layer 1a, the third external connecting terminal 2c-1 is provided on the bottom surface of the first dielectric layer 1a, and the third internal connecting terminal 2c-2 is provided on the top surface of the third dielectric layer 1c.

Specifically, the third conductor 2c has the third external connecting terminal 2c-1, the via hole conductor 5 that is connected to the third external connecting terminal 2c-1 and penetrates through the first dielectric layer 1a, an extension 2c-3 that is connected to the via hole conductor 5 and extends on the top surface of the first dielectric layer 1a, another via hole conductor 5 that connects between the extension 2c-3 and the third internal connecting terminal 2c-2 and penetrates through the second dielectric layer 1b and the third dielectric layer 1c, and the third internal connecting terminal 2c-2.

In the connector 6e of the second embodiment, the first external connecting terminal 2a-1, the second external connecting terminal 2b-1 and the third external connecting terminal 2c-1 serving as junctions for connecting the leads, for example, can be disposed along the first end 9a, and therefore the connector 6e can be made smaller in size in the Y-Y' direction than the connector 6 shown in Fig. 6.

In the present variation, the extension 2c-3 may also be electrically connected to the third external connecting terminal 2c-1 via the end-face extension provided on the end face of the first dielectric layer 1a on the first end 9a side, similarly to the connector 6d of the second embodiment.

### Second Variation of Second Embodiment

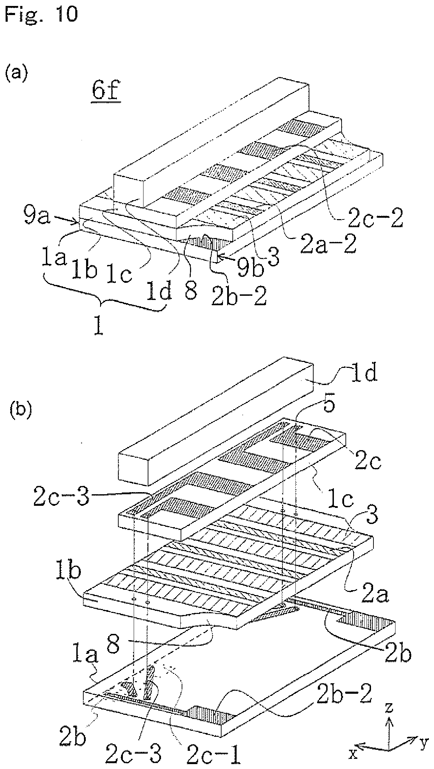

Figs. 10(a) and 10(b) show a connector 6f according to another variation of the connector 6d. Fig. 10(a) is a perspective view of the connector 6f, and Fig. 10(b) is an exploded perspective view of the connector 6f.

The via hole conductor 5b of the connector 6f penetrates through vicinities of both ends of the dielectric layers 1b, 1c (both ends in y-axis direction in Fig. 10(b)), so as not to penetrate the first conductor 2a and the grounding conductor 3.

As a result, effects similar to those of the connector 6c according to the variation of the first embodiment are obtained.

### Method for manufacturing the connector of second embodiment

The method for manufacturing the connector 6d according to the second embodiment will be described below.

Description of parts of the manufacturing method identical to those for the connector according to the first embodiment will be omitted.

Ceramic green sheets that are turned into the dielectric layers 1a, 1b, 1c, 1d are formed.

Then the electrically conductive paste prepared in the same manner as in the first embodiment is applied in a predetermined pattern by screen printing or the like at predetermined positions on the top surface of the ceramic green sheet that is turned into the top surface of the second dielectric layer 1b, thereby to form the electrically conductive paste layers that are turned into the first conductor 2a and the grounding conductor 3.

Similarly, the electrically conductive paste is applied in a predetermined pattern by screen printing or the like on the top surface, bottom surface and on the end face on the first end 9a side of the ceramic green sheet that is turned into the first dielectric layer 1a, thereby to form the electrically conductive paste layer that is turned into the second conductor 2b.

An electrically conductive paste layer that is turned into the third conductor 2c may also be formed as required at a predetermined position on the top surface of the ceramic green sheet that is turned into the third dielectric layer 1c by the same method.

After stacking the ceramic green sheets that are turned into the dielectric layers 1a, 1b, 1c, 1d in a predetermined order, the stack is fired at a temperature of about 1,600°C to obtain the connector 6d.

The connector 6d can be formed easily by the method described above, thus making it possible to provide the connector 6d characterized by high manufacturing efficiency.

When it is necessary to form the via hole conductor 5 as in the connector 6e, 6f, it may be formed by the method described in the first embodiment.

### 3. Third Embodiment

### Package

Figs. 11(a), 11(b) show a package 30 using the connector 6 according to the first embodiment of the present invention and an electronic device 50 using the package 30. Fig. 11(a) is a schematic plan view as viewed from above, and Fig. 11(b) is a schematic sectional view.

The package 30 of the present invention includes:
(a) the connector 6; and
(b) a container 10 having a cavity, a frame 12 defining the boundary of the cavity, and an aperture 13 provided on the frame 12 and communicating with the cavity.

The connector 6 is bonded onto the inner surface of the aperture 13 of the container 10, with the second end 9b positioned respectively on the inside of the container 10 and the first end 9a positioned on the outside of the container 10.

The package 30 can be made smaller in size by using the connector 6 of the first embodiment. The package 30 can be made smaller than in the conventional art also by using the connector of any of the first to third variations of the first embodiment, the second embodiment and the first and second variations of the second embodiment described above, instead of the connector 6.

Herein, the container 10 is formed from a metal such as stainless steel (SUS), copper (Cu), copper (Cu)-tungsten (W) alloy, copper (Cu)-molybdenum (Mo) alloy, iron (Fe)-nickel (Ni)-cobalt (Co) alloy or the like.

The container 10 may be formed as a predetermined shape of a single piece by applying rolling, pressing, cutting or other machining process to a metal ingot. Alternatively, it may be formed by preparing the base plate 11 forming the bottom of the container 10 and the frame 12 separately and welding the frame 12 onto the top surface of the base plate 11 by using a brazing material such as silver (Ag)-copper (Cu) brazing material. In this case, the frame 12 and the base plate 11 are bonded together by bonding the top surface of the base plate 11 and the bottom surface of frame 12 by means of a preform of a brazing material such as an Ag-Cu brazing material placed on the top surface of the base plate 11.

The frame 12 has the aperture 13 through which the connector 6 is inserted for electrically connecting the electronic device 15 and the external electronic circuit together, as described above.

When a semiconductor laser (LD), photodiode (PD) or the like is housed as the electronic device 15 in the package, an optical signal input/output window is formed as an optical transmission path for optically coupling the electronic device 15 to a part of the frame 12.

It is preferable that surface of the container 10 is coated with a metal having high corrosion resistance and high wettability with the brazing material, specifically an Ni layer 0.5 to 9 µm in thickness and a gold (Au) layer 0.5 to 5 µm in thickness formed successively by plating. This enables it to effectively prevent the container 10 from oxidation corrosion and firmly bond the electronic component 15 onto the top surface of the container 10.

### Electronic device

The electronic device 50 using the package 30 will be described below.

The electronic device 50 of the present invention includes the package 30 described above, the electronic component 15 mounted in the cavity of the package 30 and a lid 20 bonded onto the top surface of the frame 12.

In the cavity of the package 30, one end of the bonding wire is connected to the first internal connecting terminal 2a-2 of the first conductor 2a and the second internal connecting terminal 2b-2 of the second conductor 2b, while the other end of the bonding wire is connected to the electronic component 15. Thus the electronic component 15 and the connector 6 are electrically connected with each other.

The first external connecting terminal 2a-1 formed on the first conductor 2a and the second external connecting terminal 2b-1 formed on the second conductor 2b can be connected to the leads in the outside of the frame 12 (not shown). Thus electrical connection with the external circuit can be established via the leads.

While the lead may be formed from a known electrically conductive material including a metal such as iron (Fe)-nickel (Ni)-cobalt (Co) alloy or copper (Cu), Cu having low resistivity is preferably used. The lead and the external connecting terminal may be bonded together by using a brazing material such as silver (Ag)-copper (Cu) brazing material, or Ag brazing material. Electrical connection of the first external connecting terminal, the second external connecting terminal and, as required, the external connecting terminal of the grounding conductor 3 to the external electrical circuit can be established via the leads with high efficiency of work.

It is preferable that surface of the lead is coated with a metal having high corrosion resistance and high wettability with the brazing material, for example, an Ni layer 0.5 to 9 µm in thickness and a gold (Au) layer 0.5 to 5 µm in thickness formed successively by plating. This enables it to effectively prevent the lead from oxidation corrosion and firmly bond the lead and the external connecting terminal of the connector 6 together.

It is also preferable to respectively provide the first grounding conductor on the bottom surface of the first dielectric layer 1a of the connector 6, the second grounding conductor on the top surface of the fourth dielectric layer 1d and the third grounding conductor on the side face of at least one of the dielectric layers 1a, 1b, 1c, 1d disposed in parallel to the first conductor 2a and the second conductor 2b. This constitution enables it to expand the area of the grounding conductor to enhance the grounding potential, while the electrically conductive layer is formed over the entire circumference of the connector 6, so that hermetically sealed mounting onto the package is made possible via a brazing material such as Ag-Cu brazing material or Ag brazing material around the connector 6.

With this constitution, since the connector 6 is provided in the aperture 13, the package capable of suppressing the electronic device from increasing in size can be provided.

## Claims

1. A connector (6) having a first conductor (2a) and a second conductor (2b) for connecting an internal circuit formed in a frame-shaped container (10) and an external circuit provided outside of the container (10), comprising:
a stacked body comprising a plurality of dielectric layers (1a, 1b, 1c, 1d, 1e, 1f) and having a first top surface, a second top surface positioned at a height different from that of the first top surface and a bottom surface positioned opposite to the second top surface;
a first conductor (2a) comprising
a first external connecting terminal (2a-1) disposed on the first top surface of the stacked body and for connecting to the external circuit, and
a first internal connecting terminal (2a-2) disposed on the first top surface of the stacked body and for connecting to the internal circuit; and
a second conductor (2b) comprising
a second internal connecting terminal (2b-2) disposed on the second top surface and for connecting to the internal circuit, and
a second external connecting terminal (2b-1) disposed on the bottom surface and for connecting to the external circuit,
wherein the second conductor (2b) includes via hole conductor (5) penetrating the dielectric layer,
wherein the second conductor (2b) includes a primary second conductor (2b₁) and a secondary second conductor (2b₂), the secondary second conductor (2b₂) having a current capacity lower than that of the primary second conductor (2b₁), and the primary second conductor (2b₁) being disposed on the outside to interpose the secondary second conductor (2b₂), and
wherein the second conductor (2b) has transmission path longer than that of the first conductor (2a),
wherein the first conductor (2a) is configured to transmit high-frequency signals, having a frequency of 10 GHz or more, while the second conductor (2b) is configured to transmit DC or low-frequency signals, having a frequency of 1 MHz or less, each of which have a lower frequency than those of the high-frequency signals, the connector (6) further comprising a grounding conductor (3), provided on the first top surface, electrically connected to an external grounding circuit, adjoining the first conductor (2a), and forming a coplanar transmission line of G (ground) - S (signal) - G (ground) or a differential-mode transmission line G (ground) - S (signal) - S (signal) - G (ground).

2. The connector (6) according to claim 1, wherein the second conductor (2b) is disposed at positions offset in a plane so that the second conductor (2b) is not positioned right above or right below the first conductor (2a).

3. The connector (6) according to claim 1, further comprising a metal layer (4) disposed between the first conductor (2a) and the second conductor (2b).

4. An electronic component housing package (30), comprising:
a frame-shaped container (10); and
the connector (6) according to claim 1 mounted on the container (10) to straddle across the inside and outside of the container (10).

5. An electronic device (50) comprising:
the electronic component housing package (30) according to claim 4;
an electronic component (15) mounted in a cavity (11) provided in the container (10) and electrically connected to the connector (6); and
a lid (20) bonded onto the container (10).

6. The connector (6) according to claim 1, wherein the first external connecting terminal (2a-1) and the second external connecting terminal (2b-1) are disposed at positions staggered in a plane with respect to a direction perpendicular to the longitudinal direction of the first conductor (2a).

## Patentansprüche

1. Ein Verbinder (6), aufweisend einen ersten Leiter (2a) und einen zweiten Leiter (2b) zum Verbinden einer in einem rahmenförmigen Behälter (10) ausgebildeten inneren Schaltung und einer außerhalb des Behälters (10) vorgesehenen äußeren Schaltung, aufweisend:
einen Stapelkörper, aufweisend eine Mehrzahl von dielektrischen Schichten (la, 1b, 1c, 1d, 1e, 1f) und mit einer ersten oberen Fläche, einer zweiten oberen Fläche, die auf einer anderen Höhe als die der ersten oberen Fläche angeordnet ist, und einer zu der zweiten oberen Fläche entgegengesetzt positionierten unteren Fläche,
einen ersten Leiter (2a), aufweisend
einen ersten externen Verbindungsanschluss (2a-1), der auf der ersten oberen Fläche des Stapelkörpers angeordnet ist und zum Verbinden mit der äußeren Schaltung vorgesehen ist, und
einen ersten internen Verbindungsanschluss (2a-2), der auf der ersten oberen Fläche des Stapelkörpers angeordnet ist und zum Verbinden mit der inneren Schaltung vorgesehen ist, und
einen zweiten Leiter (2b), aufweisend
einen zweiten internen Verbindungsanschluss (2b-2), der auf der zweiten oberen Fläche angeordnet ist und zum Verbinden mit der inneren Schaltung vorgesehen ist, und
einen zweiten externen Verbindungsanschluss (2b-1), der auf der unteren Fläche angeordnet ist und zum Verbinden mit der äußeren Schaltung vorgesehen ist,
wobei der zweite Leiter (2b) einen Durchgangslochleiter (5) aufweist, der die dielektrische Schicht durchdringt,
wobei der zweite Leiter (2b) einen primären zweiten Leiter (2b₁) und einen sekundären zweiten Leiter (2b₂) aufweist, wobei der sekundäre zweite Leiter (2b₂) eine Stromkapazität hat, die niedriger ist als die des primären zweiten Leiters (2b₁), und wobei der primäre zweite Leiter (2b₁) auf der Außenseite angeordnet ist, um den sekundären zweiten Leiter (2b₂) zwischenzuschalten, und
wobei der zweite Leiter (2b) einen Übertragungsweg hat, der länger als derjenige des ersten Leiters (2a) ist,
wobei der erste Leiter (2a) konfiguriert ist, um Hochfrequenzsignale mit einer Frequenz von 10 GHz oder mehr zu übertragen, während der zweite Leiter (2b) konfiguriert ist, um Gleichstrom- oder Niederfrequenzsignale mit einer Frequenz von 1 MHz oder weniger zu übertragen, von denen jedes eine niedrigere Frequenz als die der Hochfrequenzsignale hat, wobei der Verbinder (6) ferner einen Erdungsleiter (3) aufweist, der auf der ersten oberen Fläche vorgesehen ist, elektrisch mit einer externen Erdungsschaltung verbunden ist, benachbart zu dem ersten Leiter (2a) ist und eine koplanare Übertragungsleitung G (Erde) - S (Signal) - G (Erde) oder eine Differentialmodusübertragungsleitung G (Erde) - S (Signal) - S (Signal) - G (Erde) bildet.

2. Der Verbinder (6) gemäß Anspruch 1, wobei der zweite Leiter (2b) an in einer Ebene versetzten Positionen angeordnet ist, so dass der zweite Leiter (2b) nicht direkt über oder direkt unter dem ersten Leiter (2a) positioniert ist.

3. Der Verbinder (6) gemäß Anspruch 1, ferner aufweisend eine Metallschicht (4), die zwischen dem ersten Leiter (2a) und dem zweiten Leiter (2b) angeordnet ist.

4. Ein elektronisches-Bauelement-Aufnahmegehäuse (30), aufweisend:
einen rahmenförmigen Behälter (10) und
den Verbinder (6) gemäß Anspruch 1, der am Behälter (10) montiert ist, um sich von der Innen- zur Außenseite des Behälters (10) zu erstrecken.

5. Eine elektronische Vorrichtung (50), aufweisend:
das elektronisches-Bauelement-Aufnahmegehäuse (30) gemäß Anspruch 4,
ein elektronisches Bauelement (15), das in einem Hohlraum (11) montiert ist, der in dem Behälter (10) vorgesehen ist, und elektrisch mit dem Verbinder (6) verbunden ist, und
einen Deckel (20), der mit dem Behälter (10) verbunden ist.

6. Der Verbinder (6) gemäß Anspruch 1, wobei der erste externe Verbindungsanschluss (2a-1) und der zweite externe Verbindungsanschluss (2b-1) an Positionen angeordnet sind, die in einer Ebene relativ zu einer Richtung senkrecht zu der Längsrichtung des ersten Leiters (2a) versetzt sind.

## Revendications

1. Un connecteur (6) présentant un premier conducteur (2a) et un deuxième conducteur (2b) pour connecter un circuit interne formé dans un conteneur en forme de cadre (10) et un circuit externe prévu à l'extérieur du conteneur (10), comprenant :
un corps empilé comprenant une pluralité de couches diélectriques (la, 1b, 1c, 1d, 1e, 1f) et présentant une première surface supérieure, une deuxième surface supérieure positionnée à une hauteur différente de celle de la première surface supérieure et une surface inférieure située opposée à la deuxième surface supérieure,
un premier conducteur (2a) comprenant
une première borne de connexion externe (2a-1) disposée sur la première surface supérieure du corps empilé et destinée à être connectée au circuit externe, et
une première borne de connexion interne (2a-2) disposée sur la première surface supérieure du corps empilé et destinée à être connecté au circuit interne,
et un deuxième conducteur (2b) comprenant
une deuxième borne de connexion interne (2b-2) disposée sur la deuxième surface supérieure et destinée à être connectée au circuit interne, et
une deuxième borne de connexion externe (2b-1) disposée sur la surface inférieure et destinée à être connectée au circuit externe,
dans lequel le deuxième conducteur (2b) comprend un conducteur de trou de passage (5) pénétrant dans la couche diélectrique,
dans lequel le deuxième conducteur (2b) comprend un deuxième conducteur primaire (2b₁) et un deuxième conducteur secondaire (2b₂), le deuxième conducteur secondaire (2b₂) présentant une capacité de courant inférieure à celle du deuxième conducteur primaire (2b₁), et le deuxième conducteur primaire (2b₁) étant disposé à l'extérieur pour interposer le deuxième conducteur secondaire (2b₂), et
dans lequel le deuxième conducteur (2b) présente une voie de transmission plus longue que celle du premier conducteur (2a),
dans lequel le premier conducteur (2a) est configuré pour transmettre des signaux à haute fréquence, présentant une fréquence de 10 GHz ou plus, tandis que le deuxième conducteur (2b) est configuré pour transmettre des signaux de courant continu ou à basse fréquence, présentant une fréquence de 1 MHz ou moins, dont chacun a une fréquence inférieure à celles des signaux à haute fréquence, le connecteur (6) comprenant en outre un conducteur de terre (3), prévu sur la première surface supérieure, connecté électriquement à un circuit de terre externe, adjacent au premier conducteur (2a), et formant une ligne de transmission coplanaire de G (terre) - S (signal) - G (terre) ou une ligne de transmission en mode différentiel G (terre) - S (signal) - S (signal) - G (terre).

2. Le connecteur (6) selon la revendication 1, dans lequel le deuxième conducteur (2b) est disposé à des positions décalées dans un plan en sorte que le deuxième conducteur (2b) n'est pas positionné juste au-dessus ou juste au-dessous du premier conducteur (2a).

3. Le connecteur (6) selon la revendication 1, comprenant en outre une couche métallique (4) disposée entre le premier conducteur (2a) et le deuxième conducteur (2b).

4. Un boîtier de logement de composant électronique (30), comprenant :
un récipient en forme de cadre (10), et
le connecteur (6) selon la revendication 1 monté sur le récipient (10) pour enjamber l'intérieur et l'extérieur du récipient (10).

5. Un dispositif électronique (50) comprenant :
le boîtier de logement de composant électronique (30) selon la revendication 4,
un composant électronique (15) monté dans une cavité (11) prévue dans le récipient (10) et relié électriquement au connecteur (6), et
un couvercle (20) lié sur le conteneur (10).

6. Le connecteur (6) selon la revendication 1, dans lequel la première borne de connexion externe (2a-1) et la deuxième borne de connexion externe (2b-1) sont disposées en des positions décalées dans un plan par rapport à une direction perpendiculaire à la direction longitudinale du premier conducteur (2a).
